# EUROPEAN PATENT APPLICATION

(11) **EP 1 156 011 A1**
(43) Date of publication of application: **21.11.2001**
(21) Application number: 98967054.2
(22) Date of filing: 30.12.1998
(51) Int. Cl.: B82B 3/00

(54) **SOLID-STATE MATERIAL**

(71) Applicant: Intellikraft Limited, London, EC1M 4JN (GB)
(72) Inventor: KRUTOVA, Elena Igorevna, Moscow, 117261 (RU); SPIRIN, Jury Leonidovich, Moscow, 117261 (RU); DUBININ, Vladimir Stepanovich, Moscow, 119048 (RU); FROLOV, Dmitry Vladimirovich, Moscow, 117574 (RU)
(74) Representative: Vaughan, Christopher Tammo
(86) International application number: RU9800446
(87) International publication number: WO0040506

(57) **Abstract**

A process for the treatment of solid state materials is described, in which pores with a cross section of up to 200nm are formed in the surface layer of the material, and these pores are filled with filaments of another material or of the same material. This produces an improvement in a number of characteristics of the material, including strength and acoustic losses.

The invention may be used most successfully in the production of piezo-ceramics.

## Description

### Technology field

The invention relates to processes for the treatment of solid state materials, including steels, structural alloys, semiconductor materials, dielectrics, ferrites, piezo-ceramic materials etc., with the aim of imparting improved characteristics to them. It can also be used for the treatment of components (articles).

### Prior art

One of the known directions in the treatment of solid state materials with the aim of improving their characteristics is to provide for the presence in the surface layer of the material of certain additives to improve specific characteristics of the material, in particular, its strength.

There is a known solid state material (USSR Authorship Certificate No. 1220104), the layer of which close to the surface contains an admixture of gold as an additive.

The problem with this material is insufficient strength, due to the absence of regular ordering of the crystalline lattice in the regions close to the surface.

There is a known solid state material (V.M. Parashchenko, M.M. Rakhmankulov and A.P. Tsisin, "Technology of casting under pressure", Moscow: Metallurgiya, 1996, p. 187), the layer of which close to the surface contains an admixture of boron, carbon, sulfur, chromium or aluminium as an additive.

The problem with this material is also the absence of regular ordering of the crystalline lattice in the regions close to the surface.

There is a known piezo-ceramic material (USSR Authorship Certificate No. 1172906) on the basis of a solid solution of oxides of zirconium, lead and barium, the layer of which close to the surface contains an enhanced concentration of lead (by 0.5-0.8% overall), which leads to the formation of additional surface centres of crystallisation.

However, this material too has insufficient strength, due to the absence of regular ordering of the crystalline lattice of the monocrystalline grains in the surface layers.

### Substance of the invention

One of the aims of the invention is to raise the strength of the material by the three-dimensional ordering of the initial crystalline structure of the material in its layers close to the surface.

Another aim solved by this invention is to improve a specific characteristic of the material, namely the magnitude of acoustic losses, which is fundamentally significant for piezo-ceramic materials.

These problems are solved by the creation of a structure in the layer close to the surface of the solid state material which is new in principle.

This structure consists of pores of nanometric cross section formed in the surface layer of the material, with diameter up to 200 nm, and filaments of nanometric cross section (up to 200 nm) located in the pores, made of another material or of the same material.

For the initial material for producing the material with this surface layer structure, any solid state crystalline ceramic material (including solid composite mixtures) can be used. The initial material may be a conductor (e.g. copper, nickel, titanium, steel) or a semiconductor (e.g. silicon, gallium arsenide).

The formation of a "nanofilament laid in nanopore" structure facilitates a significant reduction in the level of acoustic losses of the solid state material and an increase in its strength due to the three-dimensional ordering of the crystalline structure along the boundaries of the "nanofilament laid in nanopore" structures. For piezo-active materials, this effect leads to an increase in the quantity of domains, the polarisation vector of which is aligned normally to the surface of the "nanofilament laid in nanopore" structure.

Such metals as silver, gold, platinum or copper should be used as the material for the filaments for piezo-ceramics.

Another object of the invention is a process for the treatment of solid state material consisting of forming the said "nanofilament laid in nanopore" structure in its surface layer. In this, the formation of the nanopores can be achieved by the electrical erosion treatment of the surface of the blank of the material, and the filling of them with nanofilaments by local ion precipitation of the filament material.

A further object of the invention is a process for the treatment of finished components (articles) of solid state materials by forming the said "nanofilament laid in nanopore" structure in the surface layer.

### Examples of the implementation of the invention.

### Example 1. Piezo-ceramic with metal filaments laid in pores.

Nanopores are formed on one of the endfaces of a piezo-ceramic blank produced by standard technology (pressed piezo-ceramic charge with binder is fired at temperature 1450°C and gradually cooled) by the electrical erosion method using a first probe of point diameter 20 nm, made of antimony sulfoiodide (SSbI), by supplying pulses of negative polarity (pitch of treatment - 600 nm, modifying voltage 4 V; treatment time for each pore - 400 nsec). A second probe, made of silver (point diameter 10 nm) is then used, with pulses of positive polarity supplied, to form nanofilaments of Ag in the formed nanopores by the method of local ion precipitation (pitch of treatment - 600 nm; modifying voltage 2 V; treatment time for each pore 600 nsec). The positioning of the first and second probes is carried out with the aid of a scanning tunnel microscope. The concentration of pores averaged 3 pores per µm².

A piezo-ceramic plate treated by the described method was subjected to study for strength (breaking strain). This was 3100 n/mm², whereas the strength of an analogous plate which had not been subjected to this treatment was 2200 n/mm².

The electromechanical coupling coefficient, which is inversely proportional to the value of the acoustic losses in the material, increased from 0.71 to 0.85.

### Example 2. Metal with semiconductor filaments laid in the pores.

The initial material is tungsten. Pores of cross section 10-200 nm are formed in the surface of the tungsten to a depth of 100-1000 nm. The pores are filled with filaments of length 100-1000 nm, cross section 10-200 nm. The concentration of pores averages 3 pores per µm². The filament material is silicon.

The strength of studied tungsten wire without the use of the "nanofilament laid in nanopore" structure was 3600 n/mm². With the use of the "nanofilament laid in nanopore" structure, the strength after treatment was 4400 n/mm². The coefficient of acoustic losses in the material was thereby reduced on average by 20%.

### Example 3. Metal with dielectric filaments laid in the pores.

The initial material is tungsten. Pores of cross section 10-200 nm are formed in the surface of the tungsten to a depth of 100-1000 nm. The pores are filled with filaments of length 100-1000 nm and cross section 10-200 nm. The concentration of pores averages 3 pores per µm². The filament material is sulfur.

The strength of studied tungsten wire without the use of the "nanofilament laid in nanopore" structure was 3600 n/mm². With the use of the "nanofilament laid in nanopore" structure, after treatment, the strength was 4100 n/mm².

The coefficient of acoustic losses in the material was thereby reduced on average by 20%.

## Claims

1. A treatment process for solid state materials, **characterised in that** it includes the following operations:
- the provision of a blank of solid state material;
- the formation of pores at least in the surface layer of the blank material, said pores having a diameter of up to 200nm;
- the filling of the said pores with filaments made from a different material or from the same material as that of the blank.

2. A process in accordance with claim 1, **characterised in that** several nanofilaments are placed in each pore.

3. A process in accordance with claim 1 or 2, **characterised in that** the pores are formed in the material by electrical erosion treatment, and the filling of the pores is carried out by local ion precipitation of the filament material.

4. A process in accordance with any of claims 1 to 3, **characterised in that** the material being treated is a ceramic material, and the material for filling the pores is metal.

5. A process in accordance with any preceding claim, **characterised in that** the material being treated is piezo-ceramic.

6. A process in accordance with any of claims 1 to 5, **characterised in that** the material for filling the pores is silver.

7. A process in accordance with any of claims 1 to 5, **characterised in that** the material for filling the pores is gold.

8. A process in accordance with any of claims 1 to 5, **characterised in that** the material for filling the pores is platinum.

9. A process in accordance with any of claims 1 to 5, **characterised in that** the material for filling the pores is copper.

10. A process in accordance with any of claims 1 to 3, **characterised in that** the material being treated is metal, and the material for filling the pores is a semiconductor material.

11. A process in accordance with any of claims 1 to 3, **characterised in that** the material being treated is metal, and the material for filling the pores is a dielectric material.

12. A process for treating components, comprising:
- the formation of pores at least in the surface layer of the material from which the component being treated is made, said pores having a size of up to 200nm;
- filling the said pores with filaments made from a different material or from the same material as that of the component.

13. A process in accordance with claim 12, **characterised in that** the pores are formed in the material of the component by electrical erosion treatment, and the filling of them is carried out by local ion precipitation of the filament material.

14. A process in accordance with claim 12 or 13, **characterised in that** the component being treated is made of a ceramic material, and the pore-filling material is metal.

15. A process in accordance with any of claims 12 to 14, **characterised in that** the component being treated is made of a piezo-ceramic material.

16. A process in accordance with any of claims 12 to 15, **characterised in that** the material for filling the pores is silver.

17. A process in accordance with any of claims 12 to 15, **characterised in that** the material for filling the pores is gold.

18. A process in accordance with any of claims 12 to 15, **characterised in that** the material for filling the pores is platinum.

19. A process in accordance with any of claims 12 to 15, **characterised in that** the material for filling the pores is copper.

20. A process in accordance with claim 12 or 13, **characterised in that** the component being treated is made of metal, and the material for filling the pores is a semiconductor material.

21. A process in accordance with claim 12 or 13, **characterised in that** the component being treated is made of metal, and the material for filling the pores is a dielectric material.

22. A solid state material, **characterised in that** pores with a diameter of 10 to 200nm are formed at least in a surface layer of the material, and filaments of a different material are placed in the pores.

23. A solid state material, **characterised in that** pores with a diameter of 10 to 200nm are formed at least in a surface layer of the material, and filaments of the same material are placed in the pores.

24. A material as claimed in claim 22 or 23, **characterised in that** the pores have a depth from 100 to 1000nm.

25. A material as claimed in claim 22 or claim 24 depending from claim 22, **characterised in that** it is a ceramic material, and the filaments filling the pores are made of metal.

26. A material as claimed in any of claims 22 to 25, **characterised in that** it is piezo-ceramic.

27. A material as claimed in any of claims 22 to 26, **characterised in that** the filaments filling the pores are made of silver.

28. A material as claimed in any of claims 22 to 26, **characterised in that** the filaments filling the pores are made of gold.

29. A material as claimed in any of claims 22 to 26, **characterised in that** the filaments filling the pores are made of platinum.

30. A material as claimed in any of claims 22 to 26, **characterised in that** the filaments filling the pores are made of copper.

31. A material as claimed in claim 22 or any claim depending ultimately from claim 22, **characterised in that** it is metal, and the filaments filling the pores are made of a semiconductor material.

32. A material as claimed in claim 22 or any claim depending ultimately from claim 22, **characterised in that** it is metal, and the filaments filling the pores are made of a dielectric material.
